# EUROPEAN PATENT APPLICATION

(11) **EP 2 498 350 A1**
(43) Date of publication of application: **12.09.2012**
(21) Application number: 11290115.2
(22) Date of filing: 08.03.2011
(51) Int. Cl.: H01S 5/06, H01S 5/50, H01S 5/026

(54) **High speed reflective SOA**

(71) Applicant: Alcatel Lucent, 75007 Paris (FR)
(72) Inventor: Brenot, Romain, 75001 Paris (FR); De Valicourt, Guilhem, 91460 Marcoussis (FR)
(74) Representative: MERH-IP Matias Erny Reichl Hoffmann

(57) **Abstract**

The present document relates to optical transmission systems. In particular, the present document relates to emitters for optical transmission systems such as passive optical networks (PON). An optical emitter (200) configured to emit a modulated optical signal (212) at a first wavelength is described. The emitter (200) comprises an input port configured to receive a continuous wave signal (110) at the first wavelength; a laser (201) configured to emit a modulated laser signal (214) at a second wavelength; wherein the modulated laser signal (214) is associated with a modulation signal; a semiconductor optical amplifier (101) configured to overlay the continuous wave signal (110) and the modulated laser signal (214), thereby yielding the modulated optical signal (212), wherein the modulated optical signal (212) is associated with the modulation signal; and an output port configured to emit the modulated optical signal (212).

## Description

The present document relates to optical transmission systems. In particular, the present document relates to emitters for optical transmission systems such as passive optical networks (PON).

Reflective SOAs (semiconductor optical amplifier) may be a candidate for the upstream emitters for future access networks, such as NG-PON2 (next generation - passive optical networks). Currently, the modulation bandwidth of Reflective SOAs (RSOA) is typically limited to 2.5 Gbit/s applications. Since the next generation NG-PON1 may comprise emitters at 2.5 or 10 Gbit/s, operators will prefer a NG-PON2 option which is compatible with both of these bit-rates. In other words, RSOA should be compatible with a 10 Gbit/s operation in order to be selected for NG-PON2. In view of the current limitation of the modulation bandwidth of RSOAs to 2.5 Gbit/s, the present document describes RSOA configurations which are suitable for a 10 Gbit/s operation, i.e. which allow for a modulation bandwidth of 10 Gbit/s or more.

In D. Torrientes et al, Proc. Of OFC'10, paper JThA28 an RSOA with electronic compensation (EDC) is described which shows reasonable performances at 10 Gbit/s. However, EDC may be too costly and may consume too much power for access networks, such as PON. This is particularly relevant, since one EDC module is typically located at each Optical Network Terminal (ONT) of the PON.

In view of the above, the present document describes a cost-effective RSOA setup which allows for an increased modulation bandwidth (notably 10Gbit/s or higher).

According to an aspect, an optical emitter configured to emit a modulated optical signal at a first wavelength is described. The first wavelength may be a wavelength in the C band. The optical emitter may be a colorless optical emitter configured to emit a modulated optical signal at various different first wavelengths. The emitter may comprise an input port configured to receive a continuous wave signal at the first wavelength. As such, the emitter may be configured to generate a modulated optical signal from the continuous wave signal for a range of different first wavelengths.

The emitter may comprise a laser configured to emit a modulated laser signal at a second wavelength. The laser may be a quantum well laser and/or a distributed feedback laser. The second wavelength may be different and/or independent from the first wavelength. By way of example, the second wavelength may be a wavelength in the S band. The second wavelength may be fixed, whereas the first wavelength may vary dependent on the received continuous wave signal. As such, the emitter may comprise the same (kind of) laser, regardless the first wavelength.

The modulated laser signal may be associated with a modulation signal. In particular, the laser may comprise an electrode, configured to receive a modulated drive current, wherein the modulated drive current is associated with the modulation signal. In particular, the modulated laser signal and/or the modulated drive current may be modulated according to a conjugate of the modulation signal.

The emitter may comprise a semiconductor optical amplifier configured to overlay the continuous wave signal and the modulated laser signal, thereby yielding the modulated optical signal. In particular, the modulated optical signal may be generated within the semiconductor optical amplifier from the continuous wave signal by cross gain modulation with the modulated laser signal.

Consequently, the modulated optical signal may be associated with the modulation signal. In particular, if the modulated laser signal is modulated according to a conjugate of the modulation signal, the modulated optical signal may be modulated according to the modulation signal.

The semiconductor optical amplifier may comprise an electrode configured to receive a drive current. The drive current may be a continuous drive current and thereby facilitate the cross gain modulation from the modulated laser signal to the continuous wave signal. Alternatively or in addition, the drive current may be modulated and thereby provide an additional modulation to the modulated optical signal.

The emitter may comprise an output port configured to emit the modulated optical signal. The output port may be the same as the input port. In particular, the input port and the output port may be positioned upstream of a first end of the semiconductor optical amplifier. The emitter may further comprise a reflective section downstream of a second end, opposite of the first end, of the semiconductor optical amplifier (101), configured to reflect optical signals at the first wavelength. As such, the continuous wave signal may enter the emitter at the input port upstream of the semiconductor optical amplifier and then traverse the semiconductor optical amplifier. Downstream of the semiconductor optical amplifier, the continuous wave signal and/or the modulated optical signal may be reflected by the reflective section and re-traverse the semiconductor optical amplifier towards the output port. The reflective section may correspond to the endface of an optical waveguide of the emitter.

The semiconductor optical amplifier and/or the laser may comprise an active material comprising Gallium, Indium, Arsenide and/or Phosphorous. By way of example, the active materials may comprise a combination of the above mentioned active materials. As such, the semiconductor optical amplifier and the laser may be integrated on a joint photonic integrated circuit, e.g. using a common substrate.

As indicated above, the emitter may comprise an optical waveguide. In particular, the optical emitter may comprise a common optical waveguide traversing the semiconductor optical amplifier and the laser. The continuous wave signal may enter the waveguide of the emitter at a position upstream of the emitter. The laser may be positioned downstream of the second end of the semiconductor optical amplifier, meaning that after entering the emitter, the continuous wave signal first traverses the semiconductor optical amplifier and then possibly the laser. Alternatively, the laser may be positioned between the input and/or the output port and the first end of the semiconductor optical amplifier, meaning that after entering the emitter, the continuous wave signal first traverses the laser and then the semiconductor optical amplifier.

The optical emitter may further comprise an optical coupler configured to couple the continuous wave signal and the modulated laser signal onto a joint waveguide coupled to the semiconductor optical amplifier. As such, the laser may be positioned in parallel to an input and/or output port and the coupler may be used to join the continuous wave signal and the modulated laser signal onto a joint waveguide upstream of the semiconductor optical amplifier.

According to a further aspect a photonic integrated circuit (PIC) is described. The PIC may comprise an optical emitter having any combination of the features outlined in the present document.

According to another aspect an optical access network, e.g. a passive optical network, is described. The optical access network may comprise an optical line terminal (OLT) configured to emit a continuous wave signal at a first wavelength. Furthermore, the network may comprise one or more optical network terminals (ONT) comprising an optical emitter according to any of the aspects outlined in the present document. The emitter may be configured to emit a modulated optical signal at the first wavelength subject to receiving the continuous wave signal.

According to another aspect, a method for emitting a modulated optical signal at a first wavelength is described. The method may comprise the step of receiving a continuous wave signal at the first wavelength. Furthermore, the method may comprise the step of generating a modulated laser signal at a second wavelength. The modulated laser signal may be associated with a modulation signal. Subsequently, the continuous wave signal and the modulated laser signal may be overlaid in a semiconductor optical amplifier, thereby yielding the modulated optical signal. The modulated optical signal may be associated with the modulation signal. Finally, the modulated optical signal may be emitted.

It should be noted that the methods and systems including its preferred embodiments as outlined in the present patent application may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner.

The claimed subject-matter is explained below in an exemplary manner with reference to the accompanying drawings, wherein
Fig. 1 illustrates an example RSOA configuration;
Fig. 2 illustrates an example high speed RSOA configuration;
Fig. 3a and 3b illustrate example integrated high speed RSOA configurations;
Fig. 4 illustrates example integrated high speed RSOA configurations in a parallel integration scheme; and
Fig. 5 illustrates an example PON network.

In a RSOA, the modulation speed is typically limited by the carrier recombination time when dropping from a "1" to a "0", i.e. when changing the drive current of the RSOA from a high state to a low state. It has been observed that the reason for this limitation is that when the RSOA current decreases, the photon density decreases and by consequence the carrier lifetime increases.

On the other hand, in order to increase the speed of carrier recombination, the carrier recombination should be triggered by carrier depletion subject to a strong illumination, and not by current reduction, subject to a drop of the drive current of the RSOA. It is therefore suggested to modulate the gain of a RSOA by cross-gain modulation. The speed of cross-gain modulation can reach e.g. up to 40 Gbit/s. In addition, gain modulation could also be induced by current modulation, i.e. by applying a modulation to the drive current of the RSOA. In order to reduce the cost of cross-gain modulated RSOA configurations, integration schemes are described which may lead to low cost devices and packages required e.g. in access networks such as PON.

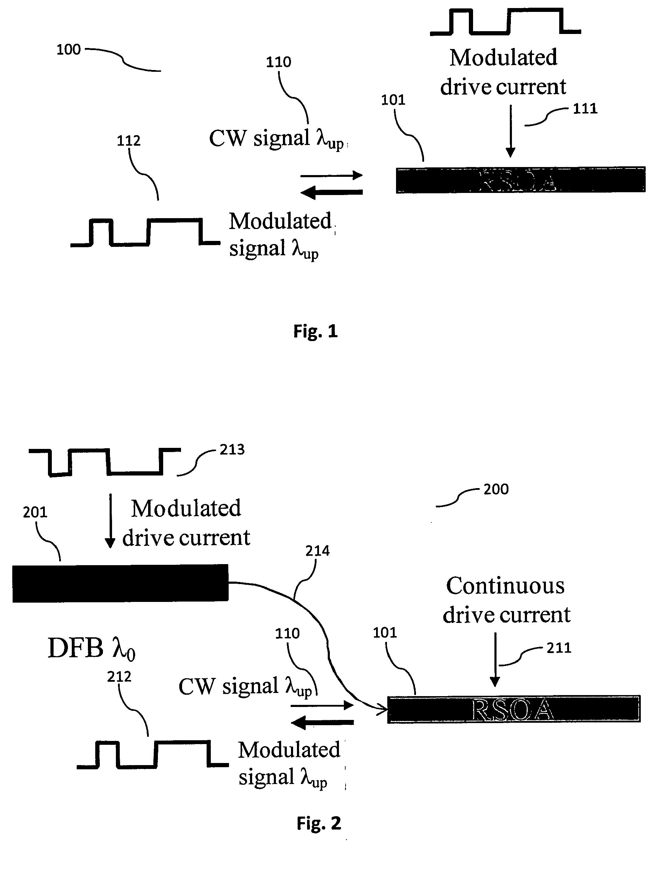

Fig. 1 illustrates a RSOA configuration 100, where the RSOA gain is modulated by current injection. The RSOA configuration 100 comprises the RSOA 101 which receives a continuous wave (CW) optical signal 110 at a certain wavelength λᵤₚ. The CW signal 110 enters the RSOA 101 at an input/output port which is provided e.g. by the endface of an optical waveguide traversing the RSOA 101. The CW signal 110 traverses the RSOA 101 (e.g. within the waveguide) and may be reflected at a second end of the RSOA 101 (opposite of the input/output port), such that the CW signal 110 re-traverses the RSOA 101 and leaves the RSOA 101 at the input/output port. While traversing the RSOA 101, the CW signal 110 may be amplified by the RSOA 101 through the application of a drive current 111 at an electrode of the RSOA 101. If the drive current 111 is modulated, the CW signal 110 is amplified in a modulated manner, thereby modulating the CW signal 110, and thereby yielding the modulated output signal 112 at the output port of the RSOA 101. The wavelength λᵤₚ of the modulated output signal 112 at the output of the RSOA 101 corresponds to the wavelength λᵤₚ of the CW signal 110 at the input of the RSOA 101.

As indicated above, the modulation bandwidth of the current modulation described in the context of Fig. 1 is typically limited to around 2.5Gbit/s. In view of this limitation, it is proposed to modulate the gain of the RSOA 101 through a Cross-Gain Modulation process (XGM), wherein the speed of XGM can be compatible with 10 Gbit/s and higher operation (e.g. 40 Gbit/s). In particular, it is proposed to modulate an additional laser with the conjugate of the upstream signal. Laser modulation bandwidth can exceed 20 GHz and may reach 40 Gbit/s or higher. The RSOA 101 may be driven by a continuous current. However, this current could also be modulated in certain applications, in order to provide for additional means of modulation. An example configuration 200 which exploits the above mentioned cross-gain modulation process is illustrated in Fig. 2.

In a similar manner to Fig. 1, a CW signal 110 at a wavelength λᵤₚ enters the RSOA 101 at the input/output port. In addition, a modulated laser signal 214 at a wavelength λ₀ enters the RSOA 101 at the input/output port. The modulated laser signal 214 may be generated using a laser 201, e.g. a DFB laser, wherein the laser light is modulated via a modulated drive current 213 of the laser 201. Both signals, i.e. the modulated laser signal 214 and the CW signal 110, traverse the RSOA 101 (e.g. within the optical waveguide of the RSOA 101), are reflected at the reflective end of the RSOA 101 and re-traverse the RSOA 101 to finally exit the RSOA at the input/output port of the RSOA 101. While the two signals 214, 110 traverse (and re-traverse) the RSOA 101, the CW signal 110 is modulated according to the modulation of the modulated laser signal 214. This phenomenon is referred to as cross-gain modulation. In order to enable and/or improve the cross-gain modulation between the modulated laser signal 214 and the CW signal 110, a drive current 211 is applied to the RSOA 101. As indicated above, the drive current 211 can be continuous or possibly modulated. In the latter case, the CW signal 110 is also current modulated according to the modulation of the modulated drive current 211.

At the output of the RSOA 101 a modulated output signal 212 at the wavelength λᵤₚ of the CW signal 110 is obtained. The modulated output signal 212 is modulated according to the modulation of the modulated laser signal 214 (and possibly according to the modulation of the drive current 211). As the modulated laser signal 214 may have been modulated at e.g. 40Gbit/s, the modulated output signal 212 is also modulated at 40Gbit/s. As such, the RSOA configuration 200 enables the generation of a modulated output signal 212 at a desired wavelength λᵤₚ which may be modulated at 10Gbit/s or higher.

The wavelength λᵤₚ of the modulated output signal 212 corresponds to the wavelength of the CW signal 110. The wavelength λ₀ of the modulated laser signal 214 may be different from the wavelength λᵤₚ of the modulated output signal 212. In particular, the same wavelength λ₀ of the modulated laser signal 214 may be used, regardless the wavelength λᵤₚ of the modulated output signal 212. By way of example, the wavelength λ₀ may be a wavelength from the S band, whereas the wavelength λᵤₚ of the modulated output signal 212 may be a wavelength from the C band (1530 -1565 nm) which might be used for NG-PON2 applications.

As the wavelength λᵤₚ of the modulated output signal 212 is determined by the wavelength of the CW signal 110, the RSOA configuration 200 may be the same, regardless the wavelength λᵤₚ of the modulated output signal 212. Consequently, the same RSOA configuration 200 could be used within the ONTs of a passive optical network, e.g. of Wavelength Division Multiplex (WDM) PON. The optical line terminal (OLT) at the central office could send the CW signal 110 at a particular wavelength λᵤₚ to a particular ONT and thereby determine the wavelength λᵤₚ of the modulated output signal 212, i.e. the wavelength at which the ONT is sending upstream traffic towards the OLT.

It should also be noted that the wavelength λ₀ of the laser 201 does not need to be controlled precisely, since the emitted wavelength λᵤₚ of the RSOA configuration 200, i.e. the wavelength of the modulated output signal 212 is determined by the remote feeding of the CW signal 110.

Consequently, the RSOA configuration 200 allows for a cost effective implementation of high bandwidth emitters (e.g. at 10Gbit/s or higher) in optical access networks. Only a single type of RSOA configuration 200 is required for various different wavelengths, thereby enabling high production volumes and low unit costs, as well as high flexibility during deployment. In other words, the RSOA configuration 200 is compatible with low-cost packaging and operation.

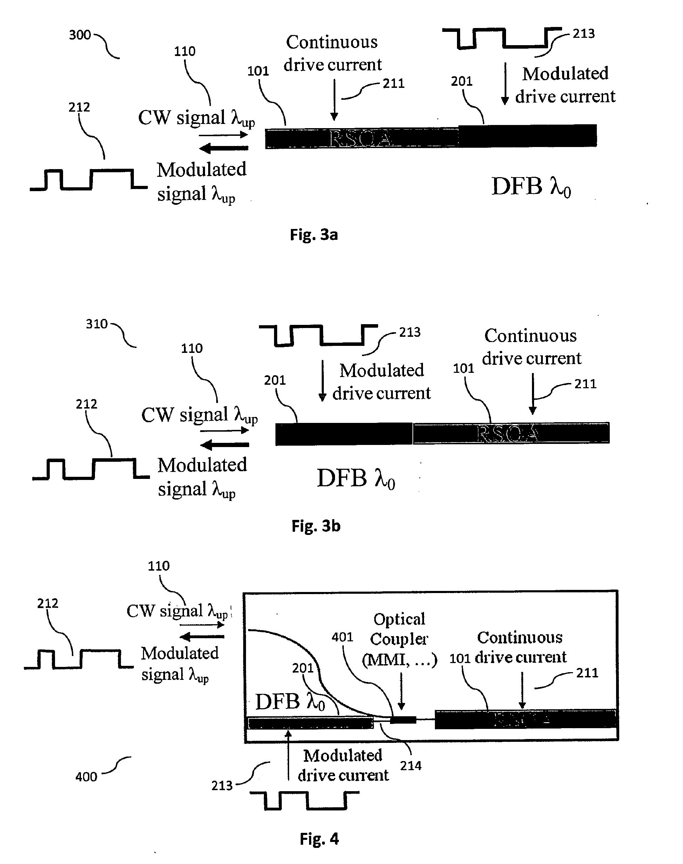

In order to further reduce the packaging costs and the footprint of the RSOA configuration 200, the laser 201 could be integrated onto a common photonic integrated circuit (PIC) with the RSOA 101. This could be done e.g. in a serial integration scheme, as illustrated in Figs. 3a and 3b, or in a parallel integration scheme, as illustrated in Fig. 4. It is expected that with such integration schemes, the cost of the final packaged device 200 does not increase significantly compared to existing stand alone RSOAs 101.

Figs. 3a and 3b illustrate example integrated RSOA configurations 300 and 310 which may work according to the cross-gain modulation principle outlined in the context of Fig. 2. In both configurations 300 and 310, the laser 201 is placed in series with the RSOA 101. The laser 201 and the RSOA 101 may comprise a common waveguide which guides the CW signal 110 and the modulated laser signal 214.

As such, in RSOA configuration 300, a CW signal 110 enters the RSOA 101 at the input/output port of the RSOA 101 and traverses the RSOA 101. The RSOA 101 may comprise a reflective section at the end opposite to its input/output port. This reflective section may e.g. be a butt joint or a wavelength selective mirror which reflects the CW signal 110, but which is transparent to the modulated laser signal 214 coming from the laser 201. The CW signal 110 is reflected at the reflective section of the RSOA 101 and re-traverses the RSOA 101 towards the input/output port. The modulated laser signal 214 enters the RSOA 101 (e.g. via the common waveguide) from the laser 201 and modulates the CW signal 110 through cross-gain modulation within the RSOA 101 (as outlined in the context of Fig. 2). Consequently, a modulated output signal 212 at the wavelength of the CW signal 110 is obtained at the output of the RSOA configuration 300.

It should be noted that the reflective section of the RSOA configuration 300 may be placed at the remote end of the laser 201 (i.e. the end of the laser 201 which is remote from the RSOA 101). In this case, the CW signal 110 would traverse and re-traverse the laser 201 (in addition to traversing the RSOA).

In the RSOA configuration 310 of Fig. 3b, the RSOA 101 and the laser 201 are interchanged. As such, the CW signal 110 enters the RSOA configuration 310 at an input/output port of the RSOA configuration 310, e.g. via a common waveguide of the laser 201 and the RSOA 101. The CW signal 110 traverses the entire configuration 310 and is reflected at the end of the RSOA 101, such that the CW signal 110 re-traverses the configuration 310 in opposite direction towards the output port of the configuration 310. As a result of cross-gain modulation with the modulated laser signal 214, a modulated output signal 212 is obtained as outlined in the context of Fig. 2.

Fig. 4 illustrates an example parallel integration scheme 400 of the RSOA configuration 200. An optical coupler 401 (e.g. a Multi-Mode Interferometer-MMI- coupler) joins the CW signal 110 (e.g. coming from an OLT) and the modulated laser signal 214 coming from the laser 201 onto a common waveguide which enters the RSOA 101. As a result of cross-gain modulation, the CW signal 110 is modulated according to the modulation of the modulated laser signal 214, thereby yielding the modulated output signal 212 which is fed towards the output port of the RSOA configuration 400. The laser 201, the coupler 401 and the RSOA 101 may be implemented on a common photonic integrated circuit.

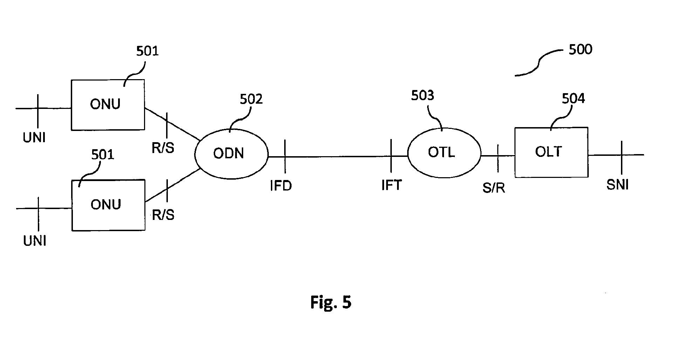

Fig. 5 illustrates an example PON network 500 with Optical Network Units (ONU) or Optical Network Terminals (ONT) 501 providing a User Network Interface (UNI). The ONUs 501 are connected to the Optical Distribution Network (ODN) 502 which may be implemented by an optical splitter/combiner. Via an Optical Trunk Line (OTL) 503, e.g. an optical fiber, the ONUs 501 are connected to the Optical Line Terminal (OLT) 504. The OLT 504 receives time multiplexed optical bursts on the upstream link from a plurality of ONUs 501.

Wavelength Division Multiplexing PON (WDM-PON) may be used for increasing the capacity of PON systems. The multiple wavelengths of a WDM-PON can be used to separate individual or groups of Optical Network Units (ONUs) 501 into several virtual PONs co-existing on the same physical infrastructure. Typically, one wavelength of the WDM system is used for the downstream communication from a central office OLT (optical line terminal) 504 to one or more ONUs 501, and another wavelength of the WDM system is used for the upstream communication from the one or more ONUs 501 to the OLT 504. The downstream and upstream communication may be performed on the same or on separate fibers.

The RSOA configurations 200, 300, 310, 400 described in the context of Figs. 2 to 4 may be used within the ONUs or ONTs 501 as optical emitters at a particular wavelength λᵤₚ. The particular wavelength λᵤₚ may be set by the OLT 504 which may send a CW signal 110 at the particular wavelength λᵤₚ to one or more ONUs 501 of the virtual PON within the WDM-PON.

In the present document methods and systems for providing colorless optical emitters at a high modulation bandwidth have been described. In particular, RSOA configurations have been described which may be used to generate optical signals at various wavelengths and to modulate these optical signals at high bandwidths such as 10Gbit/s or higher. The described solutions are completely optical and are therefore efficient with regards to the consumption of optical power.

It should be noted that the description and drawings merely illustrate the principles of the proposed methods and systems. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

In addition, it should be noted that the functions of the various elements described in the present patent document may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included.

Finally, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An optical emitter (200) configured to emit a modulated optical signal (212) at a first wavelength, the emitter (200) comprising
- an input port configured to receive a continuous wave signal (110) at the first wavelength;
- a laser (201) configured to emit a modulated laser signal (214) at a second wavelength; wherein the modulated laser signal (214) is associated with a modulation signal;
- a semiconductor optical amplifier (101) configured to overlay the continuous wave signal (110) and the modulated laser signal (214), thereby yielding the modulated optical signal (212), wherein the modulated optical signal (212) is associated with the modulation signal; and
- an output port configured to emit the modulated optical signal (212).

2. The optical emitter (200) of claim 1, wherein the semiconductor optical amplifier (101) and/or the laser (201) comprise an active material comprising Gallium, Indium, Arsenide and/or Phosphorous.

3. The optical emitter (200) of any previous claim, wherein
- the modulated laser signal (214) is modulated according to a conjugate of the modulation signal; and
- the modulated optical signal (212) is modulated according to the modulation signal.

4. The optical emitter (200) of any previous claim, wherein the laser (201) is
- a quantum well laser; and/or
- a distributed feedback laser.

5. The optical emitter (200) of any previous claim, wherein the modulated optical signal (212) is generated from the continuous wave signal (110) by cross gain modulation with the modulated laser signal (214).

6. The optical emitter (200) of any previous claim, wherein
- the semiconductor optical amplifier (101) comprises an electrode, configured to receive a drive current (211); and/or
- the laser (201) comprises an electrode, configured to receive a modulated drive current (213), wherein the modulated drive current (213) is associated with the modulation signal.

7. The optical emitter (200) of any previous claim, wherein
- the input port and the output port are positioned upstream of a first end of the semiconductor optical amplifier (101); and
- the emitter (200) further comprises a reflective section downstream of a second end, opposite of the first end, of the semiconductor optical amplifier (101), configured to reflect optical signals at the first wavelength.

8. The optical emitter (200) of any previous claim, wherein the semiconductor optical amplifier (101) and the laser (201) are integrated on a joint photonic integrated circuit.

9. The optical emitter (200) of claim 8, further comprising a common optical waveguide traversing the semiconductor optical amplifier (101) and the laser (201).

10. The optical emitter (200) of any of claims 8 to 9 referring back to claim 7, wherein the laser (201) is positioned downstream of the second end of the semiconductor optical amplifier (101).

11. The optical emitter (200) of any of claims 8 to 9 referring back to claim 7, wherein the laser (201) is positioned between the input and the output port and the first end of the semiconductor optical amplifier (101).

12. The optical emitter (200) of any previous claim, further comprising an optical coupler (401) configured to couple the continuous wave signal (110) and the modulated laser signal (214) onto a joint waveguide coupled to the semiconductor optical amplifier (101).

13. A photonic integrated circuit comprising an optical emitter (200) according to any of claims 1 to 12.

14. An optical access network (500), comprising
- an optical line terminal (504) configured to emit a continuous wave signal (110) at a first wavelength; and
- an optical network terminal (501) comprising an optical emitter (200) according to any of the claims 1 to 13, wherein the emitter (200) is configured to emit a modulated optical signal (212) at the first wavelength.

15. A method for emitting a modulated optical signal (212) at a first wavelength, the method comprising
- receiving a continuous wave signal (110) at the first wavelength;
- generating a modulated laser signal (214) at a second wavelength; wherein the modulated laser signal (214) is associated with a modulation signal;
- overlaying the continuous wave signal (110) and the modulated laser signal (214) in a semiconductor optical amplifier (101), thereby yielding the modulated optical signal (212), wherein the modulated optical signal (212) is associated with the modulation signal; and
- emitting the modulated optical signal (212).

## Amended claims

### Amended claims in accordance with Rule 137(2) EPC.

**1.** An optical emitter (200) configured to emit a modulated optical signal (212) at a first wavelength, the emitter (200) comprising
- an input port configured to receive a continuous wave signal (110) at the first wavelength;
- a laser (201) configured to emit a modulated laser signal (214) at a second wavelength; wherein the modulated laser signal (214) is associated with a modulation signal;
- a semiconductor optical amplifier (101) configured to overlay the continuous wave signal (110) and the modulated laser signal (214), thereby yielding the modulated optical signal (212), wherein the modulated optical signal (212) is associated with the modulation signal;
- a common optical waveguide traversing the semiconductor optical amplifier (101) and the laser (201); and
- an output port configured to emit the modulated optical signal (212); wherein the semiconductor optical amplifier (101) and the laser (201) are integrated on a joint photonic integrated circuit; wherein the input port and the output port are positioned upstream of a first end of the semiconductor optical amplifier (101); wherein the laser (201) is positioned between the input and the output port and the first end of the semiconductor optical amplifier (101); and
- a reflective section downstream of a second end, opposite of the first end, of the semiconductor optical amplifier (101), configured to reflect optical signals at the first wavelength.

**2.** The optical emitter (200) of claim 1, wherein the semiconductor optical amplifier (101) and/or the laser (201) comprise an active material comprising Gallium, Indium, Arsenide and/or Phosphorous.

**3.** The optical emitter (200) of any previous claim, wherein
- the modulated laser signal (214) is modulated according to a conjugate of the modulation signal; and
- the modulated optical signal (212) is modulated according to the modulation signal.

**4.** The optical emitter (200) of any previous claim, wherein the laser (201) is
- a quantum well laser; and/or
- a distributed feedback laser.

**5.** The optical emitter (200) of any previous claim, wherein the modulated optical signal (212) is generated from the continuous wave signal (110) by cross gain modulation with the modulated laser signal (214).

**6.** The optical emitter (200) of any previous claim, wherein
- the semiconductor optical amplifier (101) comprises an electrode, configured to receive a drive current (211); and/or
- the laser (201) comprises an electrode, configured to receive a modulated drive current (213), wherein the modulated drive current (213) is associated with the modulation signal.

**7.** The optical emitter (200) of any previous claim, further comprising an optical coupler (401) configured to couple the continuous wave signal (110) and the modulated laser signal (214) onto a joint waveguide coupled to the semiconductor optical amplifier (101).

**8.** A photonic integrated circuit comprising an optical emitter (200) according to any of claims 1 to 7.

**9.** An optical access network (500), comprising
- an optical line terminal (504) configured to emit a continuous wave signal (110) at a first wavelength; and
- an optical network terminal (501) comprising an optical emitter (200) according to any of the claims 1 to 7, wherein the emitter (200) is configured to emit a modulated optical signal (212) at the first wavelength.
